# EUROPÄISCHE PATENTSCHRIFT

(11) **EP 2 208 542 B1**
(45) Veröffentlichungstag und Bekanntmachung des Hinweises auf die Patenterteilung: **18.05.2016**
(21) Anmeldenummer: 10000230.2
(22) Anmeldetag: 12.01.2010
(51) Int. Cl.: B05D 1/34, B41J 11/00, B41J 3/407, B05D 5/06, B44C 5/04, H05K 3/12, H05K 3/46, B05D 1/02

(54) **Verfahren zum Beschichten einer Oberfläche**
Method for coating a surface
Procédé de revêtement d'une surface

(30) Priorität: 16.01.2009 DE 102009004877
(43) Veröffentlichungstag der Anmeldung: 21.07.2010
(60) Teilanmeldung: 16152128.1
(73) Patentinhaber: Bauer, Jörg R., 88255 Baienfurt (DE)
(72) Erfinder: Bauer, Jörg R., 88255 Baienfurt (DE)
(74) Vertreter: Kramer Barske Schmidtchen Patentanwälte PartG mbB

(56) Entgegenhaltungen:
- EP-A1- 1 462 266
- WO-A1-02/00449
- WO-A2-2004/062890
- DE-A1-102006 023 117
- DE-A1-102007 022 919
- US-A- 5 707 689
- US-A1- 2003 020 767
- US-A1- 2003 049 369
- US-A1- 2004 189 768

## Beschreibung

Die Erfindung betrifft ein Verfahren zum Beschichten einer Oberfläche mittels eines Auftragsbauteils mit einer Mehrzahl von digital angesteuerten Düsen, die Flüssigkeitströpfchen abspritzen. Die Erfindung betrifft weiter ein digitales Beschichtungssystem zum Durchführen des Verfahrens.

In der WO 2004/062890 A2 ist ein Verfahren beschrieben, mit dem feste Strukturen hergestellt werden können, indem verschiedene Nanopartikel enthaltende Tinten aus einem Druckkopf auf eine Oberfläche abgespritzt werden. Die feste Struktur wird aus einer Mehrzahl von Schichten gebildet, wobei jede Schicht durch Abspritzen wenigstens einer Flüssigkeit auf die Oberfläche entsteht. Die Feststoffmaterialien können derart gewählt werden, dass eine Struktur mit einer Anode, einer Katode und einem Elektrolyt entsteht.

Die auf den selben Anmelder wie die vorliegende Anmeldung zurückgehende DE 10 2007 022 919 A1 beschreibt ein Verfahren zum Ausbilden einer Reliefoberfläche auf einem Bauteil, bei dem durch Aufspritzen einer aushärtbaren Reliefflüssigkeit auf einer Oberfläche Schichten übereinander angeordnet werden können, die ein vorbestimmtes Dickenprofil bzw. Relief aufweisen.

Die WO 02/00449 A1, die ebenfalls auf den Anmelder der vorliegenden Anmeldung zurückgeht, beschreibt ein Verfahren zum Bedrucken von Oberflächen, beispielsweise Oberflächen von Frontplatten von Küchenelementen, die mittels eines Tintenstrahldruckverfahrens mit vorbestimmten Mustern bedruckt werden.

Die US 2004/0189768 A1 beschreibt eine Vorrichtung zur Bildherstellung, bei der ein erster Tintenstrahlkopf eine erste Schicht mit ersten Dickenungleichförmigkeiten, die einem herzustellendem Bild entsprechen, aufbringt. Ein zweiter Tintenstrahlkopf druckt das herzustellende Bild. Ein dritter Tintenstrahlkopf erzeugt eine zweite Schicht mit zweiten Dickenungleichförmigkeiten, die dem aufzubringenden Bild ebenfalls entsprechen, aber größer sind als die Dicken und Ungleichförmigkeiten der ersten Schicht.

Die EP 1 462 266 A1 beschreibt eine Vorrichtung zur Herstellung eines dreidimensionalen Bildes, das in Form zweidimensionaler Bilddaten und jedem Flächenelement des zweidimensionalen Bildes zugeordneten Höhendaten gespeichert ist. Zunächst wird das zweidimensionale Bild auf einen Träger mittels einem Tintenstrahldruckverfahren gedruckt, das aushärtbare Tinten verwendet. Auf das zweidimensionale Bild werden dann entsprechend den Höhendaten lokal zusätzliche Schichten aufgebracht, so dass ein dreidimensionales Bild entsteht.

Aus der DE 10 2006 023 117 A1 ist ein Verfahren zum Bedrucken eines Substrates bekannt, bei dem zum genauen Herstellen eines Mehrfarbdekor auf einem Substrat mittels eines Inkjetdruckverfahrens zunächst eine Dekorvorlage in geeignete druckmotivbezogene Farbauszüge zerlegt wird, die überlagert das Dekor ergeben. Zum Drucken der Teilbilder werden anschließend Farben bereitgestellt, mittels derer die Teilbilder auf das Substrat übertragen werden.

Aus der US 2003/0049369 A1 ist ein Verfahren zum Herstellen eines matten mehrfarbigen Musters mit speziellem Glanz mittels Sprühbeschichtung und Härten mehrerer Beschichtungsmaterialien mit unterschiedlichen Farben auf einem sich bewegenden Gegenstand bekannt.

Die US 2003/0020767 A1 beschreibt eine Vorrichtung zur Tintenstrahlbedruckung mit einem Druckkopf, der mittels eines Abstandhalters in definiertem Abstand von der zu bedruckenden Oberfläche gehalten wird.

Die US 5,707,689 offenbart eine Bauplatte, die hergestellt wird, indem zementhaltiges Material in einer Form pressverformt wird und dann aushärtet. Die Bauplatte weist an ihrer Oberfläche konkave und konvexe Muster auf, wobei unterschiedliche Konfigurationen konkaver Musterblöcke jeweils in natürlichen Steinen entsprechenden Abmessungen ausgebildet sind und von dekorativen Verbindungen umgeben sind. Die konvexen Musterblöcke und die dekorativen Verbindungen sind in jedem Seitenbereich der Bautafeln derart gestaltet, dass sie kontinuierlich mit den entsprechenden Musterblöcken und Verbindungen benachbarter Bautafeln sind, wenn eine Mehrzahl von Bautafeln an einer Wandoberfläche befestigt werden. Die Oberfläche jeder Bautafel wird mittels eines Tintenstrahldruckverfahrens derart gefärbt, dass die konvexen Musterblöcke verschiedene Farben haben und die konvexen Musterblöcke in einem Umfangsbereich der Bautafeln jeweils die gleichen Farben haben wie diejenigen der benachbarten Bautafeln. Musterblöcke, die nicht an einen Rand einer Bautafel angrenzen, sind jeweils vollständig von dekorativen Verbindungen umgeben, die wiederum von mehreren weiteren Musterblöcken umgeben sind.

Der Erfindung liegt die Aufgabe zugrunde, ein Verfahren zu schaffen, mit dem in einfacher Weise Bauteile hergestellt werden können, die bei Beleuchtung von einer Seite und Betrachtung von der anderen Seite für unterschiedlichste Anwendungen geeignete Kontraste zeigen.

Diese Aufgabe wird mit den Merkmalen des Anspruchs 1 gelöst.

Mit dem erfindungsgemäßen Verfahren wird eine Möglichkeit geschaffen, in einfacher Weise Bauteile mit Oberflächen zu schaffen, in denen ein lichtundurchlässiger Schichtbereich an einen lichtdurchlässigen Schichtbereich angrenzt, wobei die Dicke der nebeneinander angeordneten Schichten derart gewählt werden kann, dass auch nach längerer Betätigung beispielsweise eines Schalters kein Verschleiß auftritt, der das Erscheinungsbild der Grenze zwischen dem lichtundurchlässigen Bereich und dem lichtdurchlässigen Bereich beeinträchtigt.

Die Unteransprüche 2 bis 7 sind auf vorteilhafte weitere Merkmale des erfindungsgemäßen Verfahrens gerichtet.

Der Anspruch 8 ist auf einen Schalter gerichtet, der unter Nutzung des erfindungsgemäßen Verfahrens hergestellt wird.

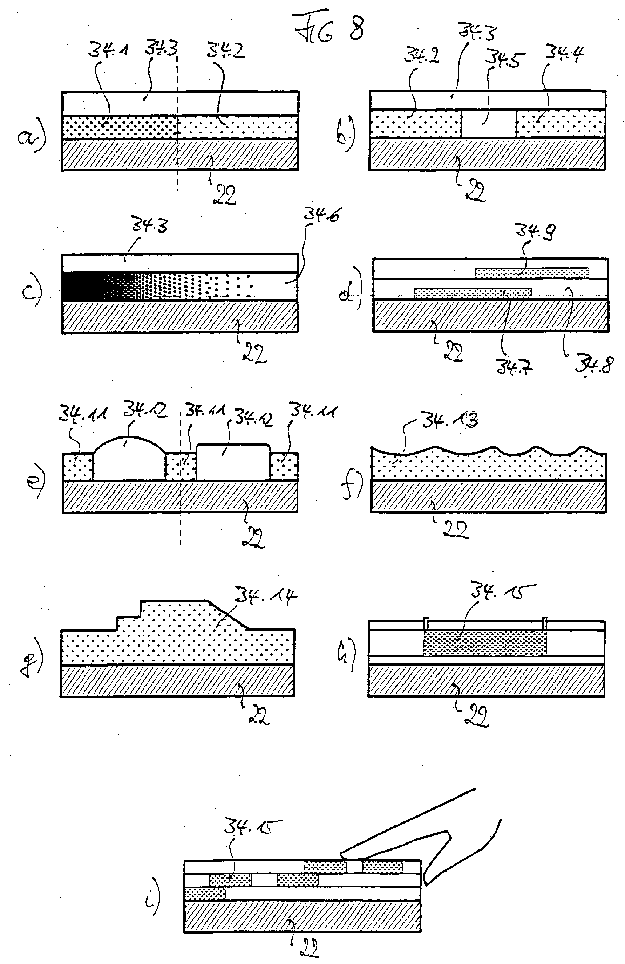

Die Erfindung, die für unterschiedlichste Anwendungen eingesetzt werden kann, wird im Folgenden anhand von Figuren beispielsweise und mit weiteren Einzelheiten erläutert, wobei lediglich die Figuren 8b) und 8e) Gegenstände betreffen, die unmittelbar unter den Schutzumfang der Ansprüche fallen und die anderen Figuren der Erläuterung von weiteren Aspekten dienen.

In den Figuren stellen dar:
- Fig. 1: eine Prinzipansicht einer in ihrem Grundaufbau an sich bekannten Vorrichtung, wie sie für die Erfindung eingesetzt werden kann,
- Fig. 2: eine Skizze zur Erläuterung des Aufbringens einer Schicht unterschiedlicher Dicke,
- Fig. 3: eine Skizze zur Erläuterung der Beschichtung einer gekrümmten Oberfläche,
- Fig. 4: eine Skizze zur Erläuterung einer weiteren Möglichkeit zur Beschichtung einer gekrümmten Oberfläche,
- Fig. 5: eine Skizze zur Erläuterung der Beschichtung einer unebenen Oberfläche,
- Fig. 6: eine weitere Skizze zur Erläuterung der Beschichtung einer unebenen Oberfläche,
- Fig. 7: eine Prinzipansicht eines vielseitig einsetzbaren digitalen Systems zur Beschichtung von Oberflächen, und
- Fig. 8: Beispiele von Beschichtungen, wie sie mit dem System gemäß Fig. 7 erzeugbar sind.

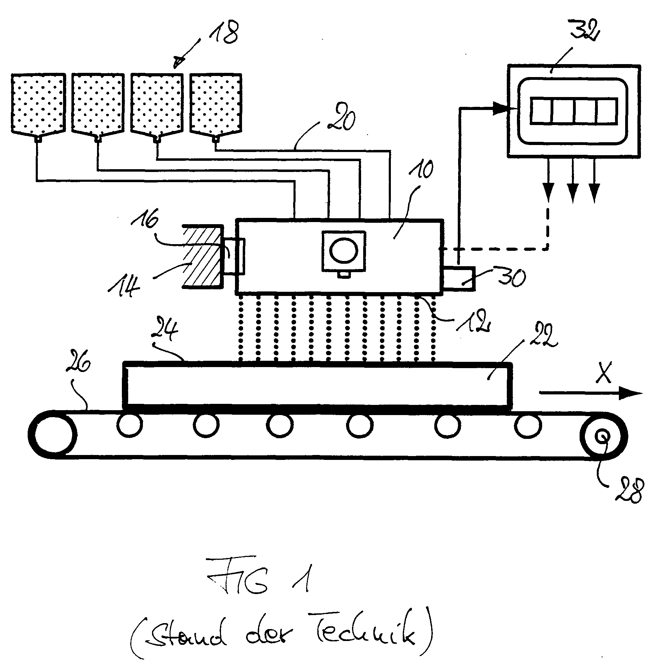

Fig. 1 zeigt eine Prinzipansicht eines an sich bekannten Systems zur Tintenstrahlbedruckung von Oberflächen. Gemäß Fig. 1 weist ein Auftragsbauteil 10 an seiner Unterseite eine Vielzahl von Düsen 12 auf. Das Auftragsbauteil 10 ist an einer ortsfesten Struktur 14 mittels einer Antriebseinheit 16 beweglich gehalten.

Ein Flüssigkeitsvorrat 18 enthält einen Vorrat von im dargestellten Beispiel 4 Flüssigkeiten, die jeweils über Leitungen 20 dem Auftragsbauteil 10 zuführbar sind.

Die Düsen 12 sind wahlweise oder permanent mit jeweils einer der Leitungen 20 verbunden und derart steuerbar, dass aus ihnen in zeitlich vorbestimmter Weise Flüssigkeitströpfchen abgespritzt werden, die vorzugsweise ein konstantes Volumen haben.

Den Düsen 12 gegenüber befindet sich ein Gegenstand 22 mit einer Oberfläche 24, die mittels des Auftragsbauteils 10 beschichtet werden soll. Der Gegenstand 22 befindet sich im dargestellten Beispiel auf einem umlaufenden Transportband 26, das mittels eines Motors, vorzugsweise eines Elektromotors 28 antreibbar ist, so dass der Gegenstand 22 im dargestellten Beispiel in Richtung des Pfeils X oder in Gegenrichtung dazu bewegbar ist.

Zur Erfassung der Position des Gegenstandes 22 bzw. von dessen Oberfläche relativ zu dem Auftragsbauteil 10 ist eine Sensoreinrichtung 30 starr mit dem Auftragsbauteil 10 verbunden oder ortsfest positioniert. Die Sensoreinrichtung ist bevorzugt derart ausgebildet, dass sie nicht nur die Position der Oberfläche 24 relativ zum Auftragsbauteil 10 erfasst, sondern auch die Art der Oberfläche bzw. einer auf der Oberfläche vorhandenen Schicht, deren Kontur usw.

Zur Steuerung des Auftragsbauteils 10, der Antriebseinheit 16 und des Motors 28 ist eine elektronische Steuereinrichtung 32 vorgesehen, deren Eingänge mit der Sensoreinrichtung 30 sowie vorteilhafterweise mit Stellungsgebern der Antriebseinheit 16 sowie des Motors 23 verbunden sind.

Die Steuereinrichtung 32 enthält ein Programm, entsprechend dem die Relativbewegung zwischen dem Auftragsbauteil 10, das im dargestellten Beispiel beispielsweise quer zur Richtung X horizontal (Y-Richtung) und vertikal (Z-Richtung) bewegbar ist, und dem Gegenstand 22 sowie koordiniert dazu das Abspritzen von Flüssigkeitströpfchen aus den Düsen 12 gesteuert wird, so dass die Oberfläche 24 entsprechend einem in der Steuereinrichtung 32 abgelegten Programm beschichtet wird.

Während bei einem konventionellen digitalen Druckverfahren, beispielsweise Tintenstrahldruckverfahren (bubble jet), die Färbeflüssigkeit in nebeneinander, gegebenenfalls in gegenseitiger Überlappung, aufgebrachten Tröpfchen aufgetragen wird, wird nach dem erfindungsgemäßen Verfahren eine Schicht auf die Oberfläche 24 aufgebracht, indem ein zu beschichtender Flächenbereich mehrfach mit Flüssigkeitströpfchen beschichtet wird, bis eine vorbestimmte Schichtdicke aufgetragen ist. Das Fließ- und Trocknungsverhalten der Flüssigkeit ist dabei auf die Relativgeschwindigkeit zwischen Auftragselement 10 und Oberfläche 24 derart abgestimmt, dass auch scharf abgestufte Flüssigkeitsschichten aufgebracht werden können. Wenn eine Flüssigkeitströpfchenschicht auf eine bereits aufgebrachte Flüssigkeitströpfchenschicht aus derselben Flüssigkeit aufgebracht wird, lösen die frischen Flüssigkeitströpfchen vorteilhafterweise die bereits aufgebrachte Flüssigkeitsschicht an und verfließen mit dieser zu einer homogenen Flüssigkeitsschicht größerer Dicke. Auf diese Weise kann auf einen vorbestimmten Oberflächenbereich eine Schicht vorbestimmter Dicke aufgebracht werden, deren Dicke entsprechend dem Beschichtungsprogramm entsprechend der Anzahl der auf dem jeweiligen Flächenbereich aufgebrachten Tröpfchenschichten unterschiedlich sein kann.

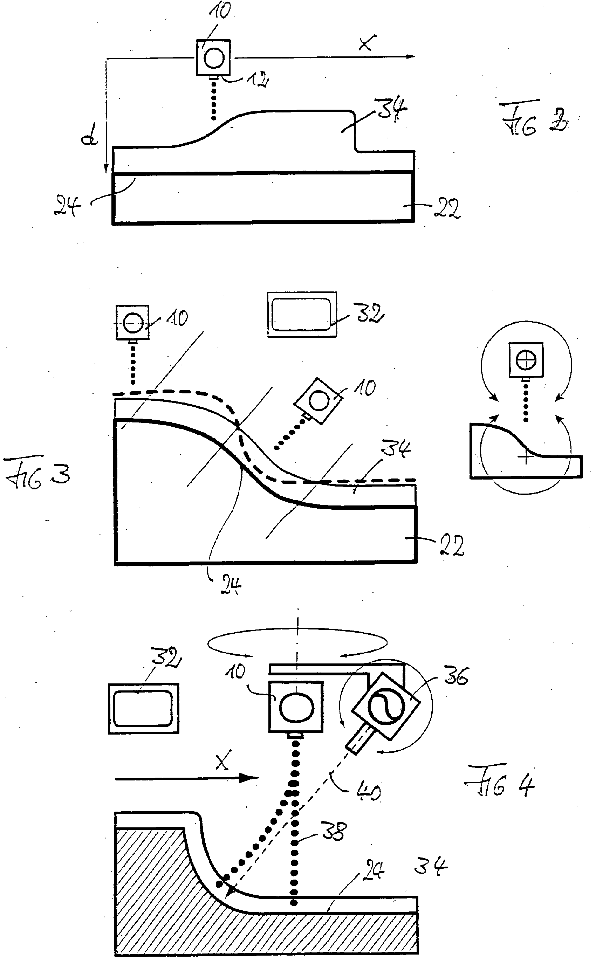

Fig. 2 skizziert eine Möglichkeit, wie auf der Oberfläche 24 eines zu beschichtenden Gegenstands 22 eine Flüssigkeitsschicht 34 unterschiedlicher Dicke d aufgebracht werden kann. X zeigt die Richtung der Relativbewegung zwischen dem Auftragsbauteil 10 und dem Gegenstand 22. Wenn sich das Auftragsbauteil 10 von gemäß Fig. 4 links längs der zu beschichtenden Oberfläche 24 bewegt, wird die je Flächeneinheit aufgebrachte Flüssigkeitsmenge erhöht, indem die von dem Auftragsbauteil 10 abgestrahlte Flüssigkeitsmenge vergrößert wird (Vergrößerung der je Zeiteinheit abgespritzten Flüssigkeitströpfchen) oder die Relativgeschwindigkeit zwischen Auftragsbauteil 10 und Gegenstand 22 vermindert wird oder die Oberfläche mehrfach hintereinander beschichtet wird, indem sich das Auftragsbauteil 10 mehrfach über den jeweiligen Flächenbereich bewegt. Wenn das Auftragsbauteil 10 bzw. die an dessen Unterseite vorgesehenen Düsen 12 sich über die gesamte Breite (senkrecht zur Zeichnungsebene der Fig. 2) erstrecken, werden nur die Düsen 12 des Auftragsbauteils 10 angesteuert, die sich über der zu beschichtenden Oberfläche 24 befinden. Das Auftragsbauteil 10 muss dann entsprechend der Dicke d der bereits aufgebrachten Schicht 33 nur in Z-Richtung (Dickenrichtung) der Schicht 33 bewegt werden, damit der Abstand zwischen den Düsen 12 und der zu beschichtenden Oberflächen zur Erzielung eines wohl definierten Auftrags konstant ist. Wenn das Auftragsbauteil 10 schmaler ist als die zu beschichtende Oberfläche 24, wird das Auftragsbauteil 10 zur flächigen Beschichtung der Oberfläche 24 bzw. eines Bereiches der Oberfläche in Y-Richtung (Breitenrichtung der Oberfläche 24) bewegt. Je nach Auftragsbedingungen ergibt sich eine langsame oder rasche Dickenzu- oderabnahme der Schicht 34. Es versteht sich, dass diese Art der Änderung der Schichtdicke vorteilhaft bei Flüssigkeiten angewendet werden kann, die rasch nach ihrem Auftrag härten. Dies kann dadurch geschehen, dass Flüssigkeiten mit rasch verdampfenden Lösungsmitteln verwendet werden oder Flüssigkeiten, die bei UV-Bestrahlung härten, wobei eine UV-Bestrahlungseinrichtung in das Auftragsbauteil 10 integriert werden kann, oder beispielsweise auch dadurch, dass aus benachbarten Düsen Flüssigkeiten abgespritzt werden, die bei ihrer gegenseitigen Vermischung bzw. Berührung aushärten.

Fig. 3 zeigt ein Beispiel, bei dem der Gegenstand 22 eine gekrümmte Oberfläche 24 aufweist. Das Auftragsbauteil 10, das zusätzlich verschwenkt werden kann, wird relativ zur Oberfläche 24 vorteilhafterweise derart bewegt, dass der Abstand zwischen den Düsen 12 und der Oberfläche 24 konstant ist und die Abspritzrichtung ständig etwa senkrecht auf der Oberfläche 24 steht. Mit der gestrichelten Linie ist die Dicke einer Flüssigkeitsschicht 34 dargestellt, die zunächst auf die Oberfläche 24 aufgebracht wird. Diese Dicke ist zunächst inhomogen und derart, dass sie sich durch ein Abwärtsfließen der noch nicht ausgehärteten Flüssigkeit längs der Oberfläche 24 vergleichmäßigt, so dass nach dem Aushärten eine Beschichtung mit gleichmäßiger Dicke erzielt wird.

Fig. 4 erläutert ein Verfahren, bei dem dem Auftragsbauteil 10 ein Gebläse 36 zugeordnet ist, das schwenkbar ist, so dass ein von dem Auftragsbauteil 10 abgestrahlter Flüssigkeitsstrahl 38 derart abgelenkt werden kann, dass er jeweils senkrecht auf eine gekrümmte Oberfläche 24 auftrifft. Wenn die Geometrie der Oberfläche 24 bekannt ist, können die Relativbewegungen zwischen der Oberfläche 24 und dem Auftragsbauteil 10 sowie die Bewegung des Gebläses 36 relativ zum Auftragsbauteil 10 von der Steuereinrichtung 30 derart gesteuert werden, dass auf der gekrümmten Oberfläche 24 eine Flüssigkeitsschicht 34 homogener Dichte abgelagert wird, die unter dem Einfluss des vom Gebläse 36 abgestrahlten Luftstrahls 38 rasch trocknet bzw. härtet.

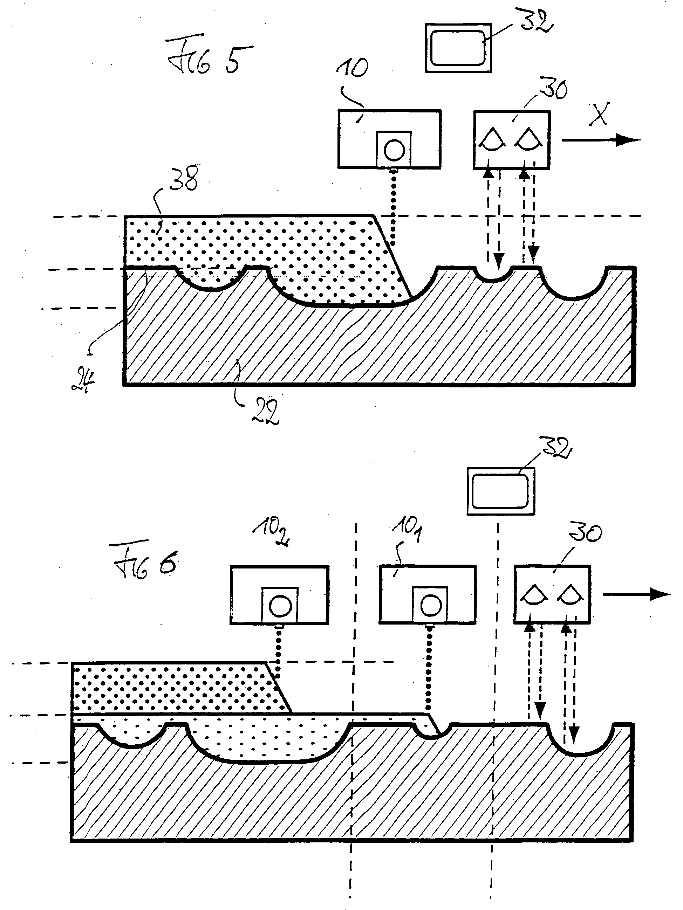

Fig. 5 erläutert ein Verfahren, bei dem eine unebene Oberfläche 24 eines Gegenstandes 22 mit einer Flüssigkeitsschicht 34 beschichtet werden kann, deren Oberfläche eben ist. Die in Richtung der Relativbewegung X vor dem Auftragsbauteil 10 angeordnete Sensoreinrichtung 30 tastet die zu beschichtende Oberfläche 24 ab. Die Abtastdaten, die das Profil der sich an der Sensoreinrichtung 30 vorbeibewegenden Oberfläche 24 angeben, werden der Steuereinrichtung 32 zugeführt, die aufgrund dieser Daten die Düsen des Auftragsbauteils 10 derart steuert, dass eine Flüssigkeitsmenge abgegeben wird, die entsprechend sich an dem Auftragsbauteil 10, das in vorbestimmter räumlicher Beziehung zur Sensoreinrichtung 30 angeordnet ist, vorbeibewegenden Vertiefungen der Oberfläche 24 zunimmt, so dass insgesamt eine ebene Oberfläche der Flüssigkeitsschicht 34 erzielt wird.

Mit der beschriebenen Vorrichtung bzw. dem beschriebenen Verfahren können beispielsweise Beschädigungen einer PKW-Lackschicht ausgebessert werden, indem eine das Auftragsbauteil 10 und die Sensoreinrichtung 30 entsprechende Einheit auf eine Karosserie aufgesetzt wird und ggfs. längs mehrerer Bahnen über die beschädigte Lackschicht geführt wird.

Die Sensoreinrichtung 30 kann einen weiteren Sensor zur Erfassung von Farbwerten der Oberfläche aufweisen. Die den Düsen des Auftragsbauteils 10 zugeführten Färbeflüssigkeiten werden entsprechend den Farbwerten gesteuert.

Fig. 6 entspricht der Fig. 5, enthält jedoch zwei in Bewegungsrichtung X hintereinander angeordnete Auftragsbauteile 10.1 und 10.2, wobei das Auftragsbauteil 10.1 eine Füllerflüssigkeit zum Erzeugen einer ebenen Oberfläche abspritzt und das Auftragsbauteil 10.2 eine Lackschicht abspritzt.

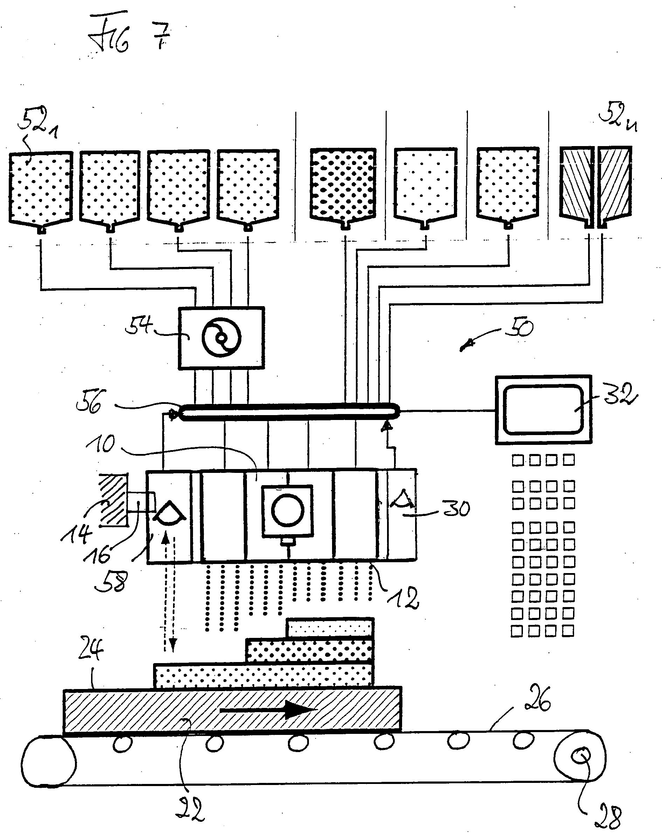

Fig. 7 zeigt den Prinzipaufbau eines digitalen Beschichtungssystems, mit dem unterschiedlichste Flüssigkeiten in unterschiedlichster Weise digital gesteuert auf eine zu beschichtende Oberfläche 24 aufgebracht werden können. Eine Flüssigkeitsversorgung enthält Vorratsbehälter 52.1 bis 52n, in denen unterschiedlichste mittels eines Auftragsbauteils abspritzbare Flüssigkeiten aufgenommen sind, beispielsweise Flüssigkeiten, wie Grundfarben, die unverändert abgespritzt werden, Flüssigkeiten, die vor dem Abspritzen in einer Mischeinheit 54 beispielsweise zum Erzeugen einer Mischfarbe gemischt werden, Flüssigkeiten, die bei ihrer Vermischung härten und aus benachbarten Farbdüsen abgespritzt werden, usw. Zu den Flüssigkeiten, die in den Vorratsbehältern 52 aufgenommen sind, gehören beispielsweise auch farblose Lacke in Matt, Seidenmatt, Seidenglanz und Glanz, lasierende Farben, deckende Farben, Farben und Suspensionen, die in ihren verschiedenen Grundkomponenten bereitgestellt werden und deren aktive Mischung erst nach dem digitalen Auftragen erfolgt, Funktionssuspensionen wie Flüssigkeiten, die durch Beimengung besondere Eigenschaften enthalten, wie elektrische Leitfähigkeit durch Beimischen von Metallteilchen, isolierende Eigenschaften, verschleißfeste Eigenschaften durch Beimischen harter Teilchen, Flüssigkeiten mit beigemischten elektromagnetisch empfindlichen Teilchen, Füller mit volumenaufbauender Wirkung, Primer mit Haft vermittelnden Eigenschaften usw. Die Flüssigkeiten werden in einer Weiche 56 auf im dargestelltem Beispiel vier Zuleitungen zum Auftragsbauteil 10 verteilt. Die Zuleitungen sind mit Gruppen von Düsen verbunden.

Die Mischeinheit 54 ist beispielsweise derart aufgebaut, dass vorbestimmte Flüssigkeitsmengen aus den Vorratsbehältern 52n zusammengemischt und in einem Zwischenbehälter (nicht dargestellt) gespeichert werden, aus dem heraus die Mischfarbe der Weiche 56 beziehungsweise den Düsen 12 zugeführt wird. Dies hat den Vorteil, dass Mischfarben in einer Menge zusammengemischt werden, die dem jeweiligen in der Steuereinrichtung 32 bekannten Bedarf entsprechen, so dass keine Verluste entstehen. Es versteht sich, dass in der Mischeinheit 54 mehrere Mischfarben beziehungsweise Flüssigkeitsgemische in vorbestimmter Menge zusammengemischt und in entsprechenden Zwischenbehältern zwischengespeichert werden können.

Zusätzlich zu der Sensoreinrichtung 30 enthält das System eine Prüfeinrichtung 58, mit der die Oberflächen von bereits aufgebrachten Beschichtungen hinsichtlich Geometrie und/oder Beschaffenheit wie Farbe, Reflexion, Leitfähigkeit usw. erfasst werden können. Die erfassten Daten werden der Steuereinrichtung 32 zur Überprüfung und/oder Steuerung weiterer Beschichtungen zugeführt.

Ein Gegenstand 22, beispielsweise ein Grundsubstrat, mit zu beschichtender Oberfläche 24 kann durch Steuerung der Weiche 56 und der Relativbewegung zwischen dem Auftragsbauteil 10 und dem Gegenstand 22 sowie der Düsen des Auftragsbauteils 10 mittels der Steuereinrichtung 32 in unterschiedlichster Weise beschichtet werden. Die Steuereinrichtung 32 enthält Programme oder ist programmierbar, so dass unterschiedlichste Beschichtungen herstellbar sind, die anhand der Fig. 10 beispielsweise erläutert werden.

Abspritzbare Flüssigkeiten sind für die Anwendung gem. Fig. 7 sowie auch gem. den anderen Figuren beispielsweise Lacke und Farben, die auf Wasser basieren, lösungsmittelhaltig sind, natürliche Harze oder Kunstharze sind, unter UV-Aushärten usw. Den Flüssigkeiten können abriebfeste Beimengungen zugemischt sein, wie beispielsweise Karundpartikel oder Glaspartikel oder Beimengungen, die andere Funktionen bewirken, wie Leitfähigkeit, magnetische Wechselwirkung usw.

Fig. 8a zeigt ein Beispiel, bei dem die Oberfläche eines Substrates 22 mit zwei unterschiedlichen, sich nicht mischenden, aneinander angrenzenden Farbschichten 34.1 und 34.2 beschichtet ist, über die eine transparente Deckschicht 34.3 aufgebracht ist.

Gemäß Fig. 8b ist ein Substrat 22 mit zwei Farbschichten 34.2, 34.4 beschichtet, zwischen denen sich ein transparenter oder transluzenter Schichtbereich 34.5 befindet. Das Ganze ist mit einer transparenten Deckschicht 34.3 überschichtet.

Mit den Beschichtungsfolgen gemäß Fig. 8a und 8b können beispielsweise Intarsienlackierungen hergestellt werden.

Fig. 8c zeigt eine Schicht 34.6, die dadurch hergestellt ist, dass auf die Oberfläche des Substrates zunächst eine Färbeflüssigkeit einer Farbe und daran anschließend zunehmend eine Färbeflüssigkeit einer anderen Farbe aufgebracht wird, wobei sich die beiden Färbeflüssigkeiten mischen. Auf die Schicht 34.6, die den Mischbereich der Färbeflüssigkeiten enthält, ist wiederum eine transparente Deckschicht 34.3 aufgebracht.

Fig. 8d zeigt ein Beispiel, in dem die Oberfläche des Substrats 22 zunächst mit einem Dekordruck 34.7 versehen wird, dann mit einer transparenten Farbschicht 34.8 versehen wird, die eine ebene Oberfläche für einen erneuten Dekordruck 34.9 bildet, der dann wiederum mit einer transparenten Flüssigkeit derart überschichtet wird, dass sich eine insgesamt ebene Oberfläche bildet. Nach dem Verfahren gemäß Fig. 8d können beispielsweise Bernsteineffekte erzielt werden.

Fig. 8e zeigt ein Beispiel, bei dem zwischen nicht lichtdurchlässigen Bereichen 34.11 lichtdurchlässige Bereiche 34.12 ausgebildet werden, deren Oberflächen unterschiedlich gekrümmt sein können. Es ergeben sich unterschiedlichste Anwendungen. Beispielsweise kann auf diese Weise ein Schalter mit beleuchteten Funktionssymbolen hergestellt werden, indem das Substrat 22 die Außenwand eines innenseitig beleuchteten Schalters bildet und die transparenten Bereiche in Form von Symbolen gestaltet sind. Bei einer gekrümmten Oberfläche ergeben sich zusätzliche Linsenfunktionen, die für eine Vergrößerung verwendet werden können. Allgemein ermöglichen erhabene oder abgesenkte Oberflächen eine haptische Erfassung eines Bedienelements. Weitere Anwendungen sind beispielsweise Fußbodenteile mit erhabenen, Rutsch hemmenden Elementen.

Fig. 8f zeigt ein Bauteil mit einer reliefartigen Beschichtung 34.13. Dateigrundlage kann ein Foto, ein Oberflächenscan einer Vorlage oder eine digital erstellte Vorlage sein. Beispielsweise lassen sich Erhebungen, wie Bilder, Dekore, Formen usw. reliefieren. Beispielsweise können folgende Oberflächen simuliert werden: Pinselstrichstrukturen, Verputztechniken, wie Reibeputz, Spachteltechniken, natürliche und organische Strukturen, Steine oder Krokohaut.

Fig. 8g zeigt eine Schicht 34.14 mit unterschiedlichen Kanten, Höhen und Höhenübergängen.

Fig. 8h zeigt ein Beispiel, bei dem in eine Beschichtung eine Flüssigkeitsschicht 34.15 integriert ist, die elektrisch leitfähig ist, so dass ein Leiternetz mittels digitaler Beschichtungstechniken herstellbar ist. Es können mehrere Netze übereinander angeordnet sein, wie in Fig. 8i dargestellt, wobei die schraffierten Beschichtungsbereiche 34.15 jeweils leitfähig sind. Es können Substrate mit integrierten Antennen, Halbleiterschaltungen usw. hergestellt werden.
Durch Veränderung von Widerständen, Kapazitäten oder Induktivitäten zwischen unterschiedlichen elektrisch leitfähigen Schichten bzw. Bahnen können druckempfindliche Schalter usw. hergestellt werden.

Die Beispiele der Fig. 8 dienen nur der Erläuterung der durch ein System gemäß Fig. 7 geschaffenen Möglichkeiten und sind nicht auf die dargestellten Beispiele beschränkt.

Die Programmierung der Steuereinrichtung 32 mit den Daten einer auf den Gegenstand 22 aufzubringenden Beschichtung, beispielsweise auch Lackierung, kann durch unmittelbare Dateneingabe von einem Datenträger oder auch durch Einscannen einer Vorlage geschehen, die beispielsweise von der Sensoreinrichtung 30 abgetastet wird. Mit der Prüfeinrichtung 58 kann dann die auf den Gegenstand 22 aufgebrachte Beschichtung abgetastet werden und die Abtastdaten können mit den von der Sensoreinrichtung erfassten Daten verglichen werden, um das Programm der Steuereinrichtung 32 derart zu verändern, dass die Abweichung zwischen den von der Sensoreinrichtung 30 unter Abtasten einer Vorlage eingescannten Daten und den von der Prüfeinrichtung 58 ermittelten Daten minimal wird.

### Bezugszeichenliste

- 10: Auftragsbauteil
- 12: Düse
- 14: Struktur
- 16: Antriebseinheit
- 18: Flüssigkeitsvorrat
- 20: Leitungen
- 22: Gegenstand
- 24: Oberfläche
- 26: Transportband
- 28: Motor
- 30: Sensoreinrichtung
- 32: Steuereinrichtung
- 34: Schicht
- 36: Gebläse
- 38: Flüssigkeitsstrahl
- 40: Luftstrahl
- 50: Flüssigkeitsversorgung
- 52: Vorratsbehälter
- 54: Mischeinheit
- 56: Weiche
- 58: Prüfeinrichtung

## Patentansprüche

1. Verfahren zum Beschichten einer Oberfläche mittels eines Auftragsbauteils mit einer Mehrzahl digital ansteuerbarer Düsen, die Tröpfchen einer aushärtbaren Flüssigkeit zur Erzeugung einer Schicht mit der abgespritzten Flüssigkeit entsprechender Dicke auf der Oberfläche abspritzen, wobei Tröpfchen derart abgespritzt werden, dass wenigstens zwei nebeneinander angeordnete und aneinander angrenzende Schichtbereiche entstehen, die aus unterschiedlichen aushärtbaren Flüssigkeiten bestehen,
**dadurch gekennzeichnet, dass**
eine der Flüssigkeiten zu einer lichtundurchlässigen Schicht aushärtet, eine andere der Flüssigkeiten zu einer lichtdurchlässigen Schicht aushärtet und die Flüssigkeiten derart auf die Oberfläche abgespritzt werden, dass die Schicht einen lichtdurchlässigen Schichtbereich aufweist, der an einen lichtundurchlässigen Schichtbereich angrenzt.

2. Verfahren nach Anspruch 1, wobei die Flüssigkeiten derart abgespritzt werden, dass der lichtdurchlässige Schichtbereich vollständig von dem lichtundurchlässigen Schichtbereich umgeben ist.

3. Verfahren nach Anspruch 1 oder 2, wobei die zu einer lichtdurchlässigen Schicht aushärtende Flüssigkeit derart abgespritzt wird, dass der lichtdurchlässige Schichtbereich eine gekrümmte Oberfläche aufweist.

4. Verfahren nach einem der Ansprüche 1 bis 3, wobei die beiden Flüssigkeiten miteinander mischbar sind.

5. Verfahren nach einem der Ansprüche 1 bis 3, wobei die beiden Flüssigkeiten nicht miteinander mischbar sind.

6. Verfahren nach einem der Ansprüche 1 bis 5, wobei auf die Schichtbereiche eine zu einer transparenten Schicht aushärtende Flüssigkeit derart aufgebracht wird, dass die Oberfläche der transparenten Schicht eben ist.

7. Schalter mit wenigstens einer aus einem lichtdurchlässigen Substrat gebildeten Wand, die entsprechend einem Verfahren nach einem der Ansprüche 1 bis 6 beschichtet ist, wobei der lichtdurchlässige Schichtbereich ein Funktionssymbol bildet.

## Claims

1. A method for coating a surface by means of an application member having a plurality of digitally controllable orifices, which eject droplets of a hardenable liquid to generate a layer with a thickness corresponding to the ejected liquid on the surface, the droplets being ejected such that at least two layer-areas are formed, which are located side by side and adjacent to each other and consist of different hardenable liquids,
**characterized in that**
one of the liquids hardens to a layer being impervious to light, another of the liquids hardens to a layer being transmissive to light, and that the liquids are ejected onto the surface such that the layer comprises a layer-area being transmissive to light, which borders on a layer-area being impervious to light.

2. The method according to claim 1, wherein the liquids are ejected such that the layer-area being transmissive to light is completely surrounded by the layer-area being impervious to light.

3. The method according to claim 1 or 2, wherein the liquid hardening to a layer being transmissive to light is ejected such that the layer-area being transmissive to light has a curved surface.

4. The method according to any of claims 1 to 3, wherein the two liquids are miscible with each other.

5. The method according to any one of claims 1 to 3, wherein the two liquids are unmiscible with each other.

6. The method according to any one of claims 1 to 5, wherein a liquid which hardens to a transparent layer is applied onto the layer-areas such that the surface of the transparent layer is planar.

7. A switch having at least one wall formed by a substrate being transmissive to light, and coated by a method according to any of claims 1 to 6, wherein the layer being transmissive to light forms a functional symbol.

## Revendications

1. Procédé de revêtement d'une surface à l'aide d'un composant d'application avec une pluralité de buses commandables par voie numérique, qui projettent des gouttelettes d'un liquide durcissable pour la génération d'une couche avec le liquide projeté d'épaisseur correspondante sur la surface, des gouttelettes étant projetées de telle manière qu'au moins deux zones de couche agencées l'une à côté de l'autre et contiguës l'une à l'autre apparaissent, lesquelles se composent de différents liquides durcissables,
**caractérisé en ce que**
l'un des liquides durcit en une couche imperméable à la lumière, un autre des liquides durcit en une couche perméable à la lumière et les liquides sont projetés sur la surface de telle manière que la couche présente une zone de couche perméable à la lumière qui est contiguë à une zone de couche imperméable à la lumière.

2. Procédé selon la revendication 1, les liquides étant projetés de telle manière que la zone de couche perméable à la lumière soit complètement entourée par la zone de couche imperméable à la lumière.

3. Procédé selon la revendication 1 ou 2, le liquide durcissant en une couche perméable à la lumière étant projeté de telle manière que la zone de couche perméable à la lumière présente une surface courbée.

4. Procédé selon l'une quelconque des revendications 1 à 3, les deux liquides pouvant être mélangés entre eux.

5. Procédé selon l'une quelconque des revendications 1 à 3, les deux liquides ne pouvant pas être mélangés entre eux.

6. Procédé selon l'une quelconque des revendications 1 à 5, un liquide durcissant en une couche transparente étant appliqué sur les zones de couche de telle manière que la surface de la couche transparente soit plane.

7. Commutateur avec au moins une paroi formée d'un substrat perméable à la lumière qui est revêtue selon un procédé selon l'une quelconque des revendications 1 à 6, la zone de couche perméable à la lumière formant un symbole fonctionnel.
